# EUROPEAN PATENT APPLICATION

(11) **EP 4 557 060 A1**
(43) Date of publication of application: **21.05.2025**
(21) Application number: 23851768.4
(22) Date of filing: 07.08.2023
(51) Int. Cl.: G06F 3/02, G06F 3/023, H01H 13/14, H01H 13/84

(54) **TOUCH-CONTROL KEY CAP, KEYBOARD, AND KEYBOARD TOUCH-CONTROL INPUT ASSEMBLY**

(30) Priority: 09.08.2022 CN 202210954676; 09.08.2022 CN 202222094783 U; 03.08.2023 CN 202310976485
(71) Applicant: XX HMI Electronics Co., Ltd, Guangzhou, Guangdong 510030 (CN)
(72) Inventor: LIN, Yanyu, Guangzhou, Guangdong 510030 (CN)
(74) Representative: Zaboliene, Reda
(86) International application number: PCT/CN2023/111463
(87) International publication number: WO 2024/032547

(57) **Abstract**

The present disclosure relates to a technical field of keyboards, and provides a touch keycap. The touch keycap includes a circuit board and a keycap body, where the circuit board is located on the keycap body and/or a keyboard; the circuit board is provided with a touch circuit; the touch circuit is electrically connected to a capacitive sensing touch element; the capacitive sensing touch element is one or more of a touch key, a touch slider, and a touch pad; the touch circuit is provided with a microcontroller unit (MCU); the capacitive sensing touch element is electrically connected to the MCU; the capacitive sensing touch element is located at any position of an inner surface, an interior, and an outer surface of a top wall of the keycap body; alternatively, the capacitive sensing touch element is located at any position of an inner surface, an interior, and an outer surface of a side wall of the keycap body; and alternatively, the capacitive sensing touch element is located at an edge of the keycap body. A keyboard using the touch keycap can increase the number of keys on the basis of a given number of key positions, thereby improving interaction efficiency. The present disclosure further provides a keyboard touch input assembly, which can be used in combination with a keyboard or be used alone.

## Description

### TECHNICAL FIELD

The present disclosure relates to a technical field of keyboards, and in particular to a touch keycap, a keyboard, and a keyboard touch input assembly.

### BACKGROUND

As a universal and affordable human-computer interaction device in the world, an existing keyboard typically includes a bottom case, a control circuit board, keyboard switches, a switch positioning plate (top case), and keycaps. In the early 19^{th} century, typewriters were born and keyboards took shape. Since then, the working principle and connection method of the keyboard switches inside the keyboard have gone through multiple iterations, from mechanical switches, capacitive detection switches to optical signal switches, and from wired AT interfaces, PS/2 interfaces, universal serial bus (USB) interfaces to later wireless 2.4g and Bluetooth connections. However, the interaction between humans and keyboards has almost never changed, mainly relying on pressing keys from top to bottom.

In recent years, in order to pursue desktop aesthetics and mouse movement space, or simply to adapt to small desks used in small apartments, some consumers have begun to shift from the 108-key standard (100%) layout to the 87-key layout, the 68-key layout, and the 61-key layout. The 87-key layout is also known as 80% layout, which removes the number pad, i.e. the numeric key pad. The 68-key layout is also known as 65% layout, which, based on the 80% layout, removes the function keys (F1 to F12), and simplifies the navigation keys, i.e. removes any two keys from Insert, Delete, Home, End, PageUp, and PageDown. The 61-key layout is also known as 60% layout, which removes the function keys and navigation keys. However, reducing the number of keys is a double-edged sword. Although it improves space utilization, it results in higher learning costs, higher interaction costs (requiring the use of a key combination to achieve an original single-key operation), and higher purchase costs. Regarding the higher purchase costs, the output of the emerging layouts is far less than that of the 100% layout, making it hard to generate an equivalent economy of scale in production, so the extra costs will be passed on to consumers.

Meanwhile, keyboards with a knob in the upper right corner have become popular in the market. Compared to key operations, knob operations have unparalleled intuitiveness and step accuracy/speed in specific operations such as volume adjustment, view angle adjustment, and screen zoom adjustment. However, the knob type keyboards also face cost control and interaction efficiency (the user needs to exit the posture of "typing with both hands") issues.

Overall, there is a need for a keyboard that can add more available keys on the basis of a given number and volume of keys and does not require the user to exit the posture of "typing with both hands" when operating.

### SUMMARY

A technical problem to be solved by the present disclosure is to provide a touch keycap that can add more available keys on the basis of a given number and volume of keys to facilitate operation.

In order to achieve the above-mentioned objective, the present disclosure provides a touch keycap, including a circuit board and a keycap body, where the circuit board is located on the keycap body and/or a keyboard; the circuit board is provided with a touch circuit; the touch circuit is electrically connected to a capacitive sensing touch element; the capacitive sensing touch element is one or more of a touch key, a touch slider, and a touch pad; the touch circuit is provided with a microcontroller unit (MCU); the capacitive sensing touch element is electrically connected to the MCU; the capacitive sensing touch element is located at any position of an inner surface, an interior, and an outer surface of a top wall of the keycap body; alternatively, the capacitive sensing touch element is located at any position of an inner surface, an interior, and an outer surface of a side wall of the keycap body; and alternatively, the capacitive sensing touch element is located at an edge of the keycap body.

In a preferred solution of the present disclosure, the circuit board includes a touch region and an accommodation region; the capacitive sensing touch element is located in the touch region; the touch circuit is located in the accommodation region; and the accommodation region is located on the keycap body and/or the keyboard.

In a preferred solution of the present disclosure, the circuit board is a flexible printed circuit board; the flexible printed circuit board is located on the keycap body; the touch region is fixed to the inner surface of the side wall of the keycap; and the accommodation region is located on an inner surface of a side wall of the keycap body adjacent to the touch region.

Meanwhile, based on the above-mentioned touch keycap, a keyboard includes a control circuit board and the above-mentioned touch keycap, where the touch keycap is located at a key position of the keyboard; and the touch circuit is electrically connected to the control circuit board.

In a preferred solution of the present disclosure, the touch keycap is located at an edge key position of the keyboard; an outward side of the keycap body forms a touch side; and the capacitive sensing touch element is located at any position of an inner surface, an interior, and an outer surface of a wall of the touch side.

In a preferred solution of the present disclosure, there are multiple touch keycaps; the capacitive sensing touch elements of the multiple touch keycaps are electrically connected to the same MCU to form a touch key group.

In a preferred solution of the present disclosure, there are multiple touch key groups; and each of the touch key groups is provided with one MCU.

In a preferred solution of the present disclosure, the keyboard further includes an adapter; the adapter is provided with an input interface and an output interface; the control circuit board is electrically connected to the input interface; and the output interface is configured to achieve communication connection with a computer.

Meanwhile, the present disclosure further provides a keyboard touch input assembly, including a circuit board and an adapter that is in communication connection with a control circuit board of a keyboard and/or a computer, where the circuit board is provided with a touch circuit; the touch circuit is electrically connected to a capacitive sensing touch element; the capacitive sensing touch element is one of a touch key, a touch slider, and a touch pad; the touch circuit is provided with a MCU; and the MCU is electrically connected to the capacitive sensing touch element and the adapter separately.

Compared to the prior art, the touch keycap provided in the present disclosure has following beneficial effects. When a finger touches a part of the keycap body corresponding to the position of the capacitive sensing touch element, the capacitive sensing touch element located on the keycap body senses the touch of the finger and is thus triggered to emit a signal. The signal is transmitted to the MCU, such that the MCU processes the signal and outputs a command signal. In this way, the touch keycap has a touch output function. The present disclosure further provides a keyboard using the touch keycap, which can add more available keys on the basis of a given number of key positions. Thus, the output of two or more key combinations can be triggered with one finger, and a touch slider function can be used while a state of "typing with both hands" is maintained, thereby achieving simple operation and high interaction efficiency. The touch keycap is located at the edge key position of the keyboard, and the outward side of the keycap body is the touch side, ensuring that an outer wall of the touch side of the keycap body is exposed to facilitate a user to touch and trigger the touch output function of the touch keycap. The present disclosure further provides a keyboard touch assembly that can be used in combination with a keycap of a traditional keyboard to provide an additional touch input function for the traditional keyboard, or can be used alone, equivalent to an additional touch keyboard.

### BRIEF DESCRIPTION OF THE DRAWINGS

FIG. 1 is a structural diagram of a touch keycap according to the present disclosure;
FIG. 2 is a structural diagram of the touch keycap shown in FIG. 1 from another perspective according to the present disclosure;
FIG. 3 is a structural diagram of a side groove provided at a bottom of a keycap body according to the present disclosure;
FIG. 4 is a structural diagram of a keyboard with the touch keycap according to the present disclosure;
FIG. 5 is a connection relation diagram of the touch keycap and a control circuit board according to the present disclosure;
FIG. 6 is a connection relation diagram of the touch keycap and an adapter according to the present disclosure; and
FIG. 7 is a connection relation diagram of a keyboard touch input assembly according to the present disclosure.

Reference Numerals: 1. touch keycap; 11. flexible printed circuit board; 111. capacitive sensing touch element; 112. microcontroller unit (MCU); 113. touch region; 114. accommodation region; 12. keycap body; 121. touch side; 122. side groove; 2. control circuit board; 21. adapter; and 3. computer.

### DETAILED DESCRIPTION OF THE EMBODIMENTS

The specific implementations of the present disclosure are described in more detail below with reference to the drawings and embodiments. The following embodiments are intended to illustrate the present disclosure, but not to limit the scope of the present disclosure.

It should be understood that, in the description of the present disclosure, orientation or position relationships indicated by terms such as "central", "longitudinal", "transverse", "upper", "lower", "front", "rear", "left", "right", "vertical", "horizontal", "top", "bottom", "inner", and "outer" are orientation or position relationships as shown in the drawings. These terms are merely intended to facilitate and simplify the description of the present disclosure, rather than to indicate or imply that the mentioned device or component must have a specific orientation or must be constructed and operated in a specific orientation. Therefore, these terms should not be understood as a limitation to the present disclosure. Moreover, the terms "first", "second" and "third" are used only for the purpose of description, rather than to indicate or imply relative importance.

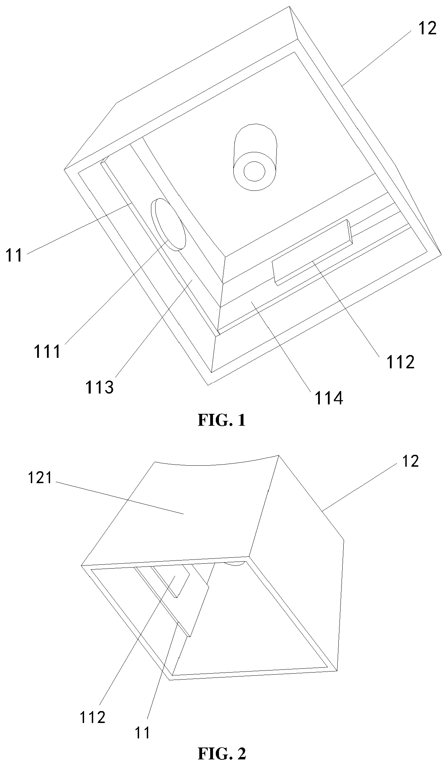

As shown in FIGS. 1 to 2, a touch keycap includes a circuit board and a keycap body 12. The circuit board is located on the keycap body 12 and/or a keyboard. That is, the circuit board is located on the keycap body 12, the circuit board is located on the keyboard, or the circuit board is located on both the keycap body 12 and the keyboard (for example, the circuit board is divided into two electrically connected parts, where one part is located on the keycap body 12, and the other part is located on the keyboard). The circuit board is provided with a touch circuit. The touch circuit is electrically connected to a capacitive sensing touch element 111. The capacitive sensing touch element 111 is one or more of a touch key, a touch slider, and a touch pad. The touch circuit is provided with a microcontroller unit (MCU) 112. The capacitive sensing touch element 111 is electrically connected to the MCU 112. One side of the keycap body 12 forms a touch side 121. The capacitive sensing touch element 111 is located at any position of an inner surface, an interior, and an outer surface of a top wall of the keycap body 12. Alternatively, the capacitive sensing touch element 111 is located at any position of an inner surface, an interior, and an outer surface of a side wall of the keycap body 12. Alternatively, the capacitive sensing touch element 111 is located at an edge of the keycap body 12. It can be understood that, under the premise of normal triggering, two or even more capacitive sensing touch elements 111 can be provided at the same part of the keycap body 12.

A working principle of this embodiment is as follows. When a finger approaches (touches) the capacitive sensing touch element 111, a capacitor in the capacitive sensing touch element 111 couples with the finger, causing a change in a capacitance in the capacitive sensing touch element 111. Therefore, whether there is a finger touch can be determined by measuring the capacitance. The capacitive sensing touch element 111 can accurately detect an effective finger touch at a distance of 20 mm or more from an insulation (such as glass or plastic) housing. Based on the above principle, when a finger touches a part of the keycap body 12 corresponding to the position of the capacitive sensing touch element 111, the capacitive sensing touch element 111 located on the keycap body 12 senses the touch of the finger, causing the capacitive sensing touch element 111 to be triggered and emit a signal. The signal is transmitted to the MCU 112 and processed by the MCU 112 to output a command signal, enabling the touch keycap 1 to have a touch output function in addition to an original keycap function. Specifically, if the capacitive sensing touch element 111 is a touch key, when a finger touches the part (top, side, or edge) of the keycap body 12 corresponding to the position of the capacitive sensing touch element 111, the touch key is triggered. That is, the touch keycap 1 in this embodiment has the function of the touch key. If the capacitive sensing touch element 111 is a touch slider, when a finger slides on the part of the keycap body 12 corresponding to the position of the capacitive sensing touch element 111, the touch slider is triggered. That is, the touch keycap 1 in this embodiment has the function of the touch slider. If the capacitive sensing touch element 111 is a touch pad, when a finger slides on the part of the keycap body 12 corresponding to the position of the capacitive sensing touch element 111, the touch pad is triggered. That is, the touch keycap 1 in this embodiment has the function of the touch pad.

The inner surface of the top wall of the keycap body refers to an inner side surface of the top wall of the keycap body 12. The interior of the top wall of the keycap body refers to an inside part of the top wall of the keycap body 12, for example, an inner side of the top wall of the keycap body 12 is provided with a top groove, and the capacitive sensing touch element 111 is embedded into the top groove. The outer surface of the top wall of the keycap body refers to an outer side surface of the top wall of the keycap body 12. When the capacitive sensing touch element 111 is located at any position of the inner surface, the interior, and the outer surface of the top wall of the keycap body 12, if a finger touches a top of the keycap body 12, the capacitive sensing touch element 111 is triggered, thereby achieving the touch output function. In order to prevent a confusion in character outputs (interference between an output enabled by touching the keycap body 12 and an output enabled by pressing the keycap body 12), a switch is needed to control the on/off of the touch function of the keycap body 12. Thus, when the touch function of the keycap body 12 is turned off, the keycap body 12 can be pressed normally to output a character, or a touch output signal can be shielded by software.

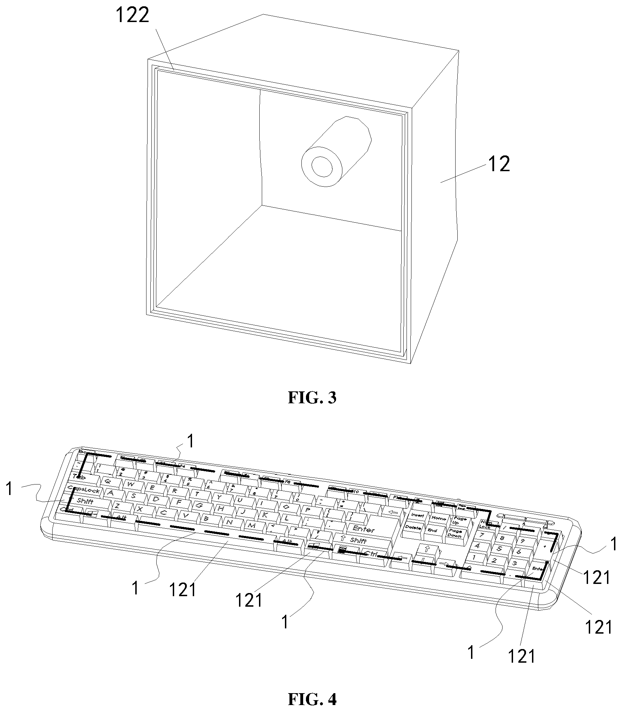

The capacitive sensing touch element 111 can be located at any position of an inner surface, an interior, and an outer surface of a wall of the touch side 121 of the keycap body 12 (i.e. a wall at one side of the keycap body 12). In this case, the inner surface refers to an inner side surface. The interior refers to an inside part of a side wall of the keycap body 12, for example, an inner side or a bottom surface of the side wall of the keycap body 12 is provided with a side groove 122, and the capacitive sensing touch element 111 is embedded into the side groove 122, as shown in FIG. 3. It can be understood that for ease of connection, in this case, the keycap body 12 needs to be provided with through-holes that are respectively communicated with the inside part and the side groove 122 of the keycap body 12. The outer surface refers to an outer side surface. Alternatively, the capacitive sensing touch element 111 is located at an edge of the keycap body 12. In this case, when a user presses the keycap body 12 to output a character, the capacitive sensing touch element 111 will not be triggered, thereby preventing the touch function from interfering with the character output function.

Exemplarily, the circuit board includes a touch region 113 and an accommodation region 114. The capacitive sensing touch element 111 is located in the touch region 113. That is, the touch region 113 is located on the keycap body 12. The touch circuit is located in the accommodation region 114, and the accommodation region 114 is located on the keycap body 12 or the keyboard. The accommodation region 114 can be located at any position of the keycap body 12, and even can be located on a control circuit board 2 or a function pad of the keyboard. In this case, the accommodation region 114 and the touch region 113 are not necessarily integrated. In other words, the accommodation region 114 and the touch region 113 can be two separated parts, which can be connected through a circuit board, a wire, a sliding rail, or even a modified conductive keyboard switch.

Exemplarily, the circuit board is a flexible printed circuit board 11. The flexible printed circuit board 11 is located on the keycap body 12. The touch region 113 is fixed to the inner surface of the side wall of the keycap. The circuit board is provided with a folded line. The folded line divides the flexible printed circuit board 11 into the touch region 113 and the accommodation region 114. The capacitive sensing touch element 111 is located in the touch region 113, while the touch circuit is located in the accommodation region 114. The touch region 113 is fixed to the inner surface of the side wall of the keycap. The accommodation region 114 is located on the keycap body 12 and on an inner surface of a side wall adjacent to the touch region 113. That is, the flexible printed circuit board 11 is folded and fixed to an inner side wall of the keycap body 12, making it easy to fix the flexible printed circuit board 11 inside the keycap body 12. Thus, the flexible printed circuit board 11 is prevented from being compressed when the keycap body 12 is pressed down, and only the capacitive sensing touch element 111 is provided on the inner surface of the side wall of the keycap body 12. A touch sensing area of the capacitive sensing touch element 111 can be set to be consistent with an area of the inner surface of the side wall of the keycap body 12, ensuring that the capacitive sensing touch element 111 can be accurately triggered. In addition, in other embodiments, the accommodation region 114 can be located on the same inner surface as the touch region 113 or on other inner surfaces, and can even overlap on a back surface of the touch region 113. Alternatively, the accommodation region 114 can be located on the inner surface of the top wall of the keycap body 12.

Meanwhile, based on the above-mentioned touch keycap 1, the present disclosure further provides a keyboard, including a control circuit board 2 and the above-mentioned touch keycap 1. The touch keycap 1 is located at a key position of the keyboard. The touch circuit is electrically connected to the control circuit board 2. When the keyboard is connected to a computer 3, the command signal output by the MCU 112 is transmitted to the computer 3. That is, since the keycap of the keyboard is the above-mentioned touch keycap 1, the keyboard has the touch output function.

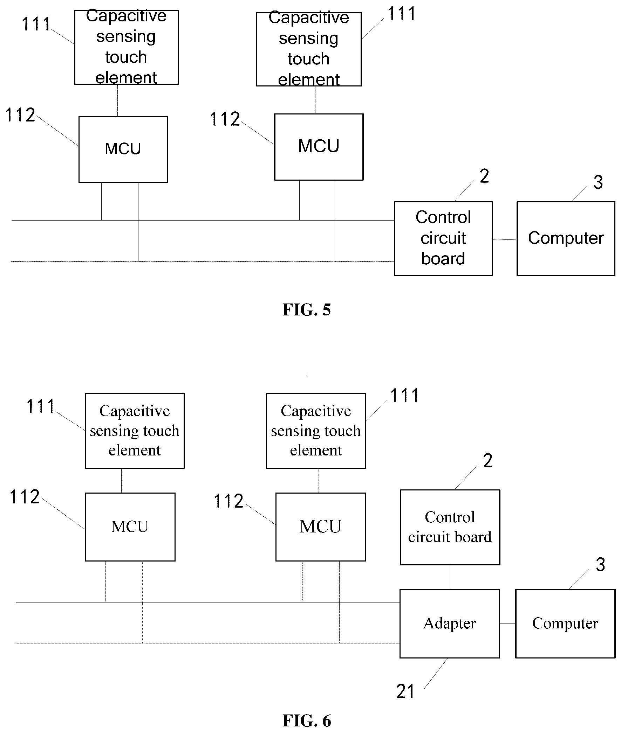

Exemplarily, as shown in FIGS. 4 to 6, the touch keycap 1 is located at an edge key position of the keyboard. An outward side of the keycap body 12 forms the touch side 121. The capacitive sensing touch element 111 is located at any position of an inner surface, an interior, and an outer surface of a wall of the touch side 121 of the keycap body 12. The edge key position refers to a key position close to an edge of the keyboard. Taking a 108-key keyboard as an example, the edge key position is a key position marked by a dashed box shown in FIG. 2. The outward side of the keycap body 12, namely a side of the keycap body 12 close to the edge of the keyboard, forms the touch side 121. As shown in FIG. 2, a front side of the keycap body 12 at the position of a "Space" key is the touch side 121. When the touch keycap 1 is located at an edge key position in a corner of the keyboard, the touch keycap 1 has two outward side surfaces. For example, for the touch keycap 1 at the position of a "Right Enter" key of the keyboard, front and right sides of the keycap body 12 form touch sides 121. In this case, the capacitive sensing touch element 111 is located on one of the two touch sides 121 (specifically at an inner surface, an interior, an outer surface, or an edge of a wall of the touch side 121), or on both the two touch sides 121. In other words, two capacitive sensing touch elements 111 are located on the two touch sides 121, respectively, or one capacitive sensing touch element 111 is located on both the two touch sides 121.

A working principle of this embodiment is as follows. The touch keycap 1 is located at the edge key position of the keyboard, and the outward side of the keycap body 12 forms the touch side 121, such that the wall of the touch side 121 of the keycap body 12 is exposed, facilitating a user to touch the touch keycap 1 and trigger the touch output function of the touch keycap.

If the capacitive sensing touch element 111 is a touch key, the touch keycap 1 can output a character command at the key position where the touch keycap is located. In addition, when the capacitive sensing touch element 111 of the touch keycap body 12 is triggered, the touch keycap 1 can output an additional character command. This character command can be modified through a program to meet a user's usage need and habit. For example, a character command output by the touch keycap 1 at the position of a "F4 key" is set to "Alt". Thus, when a finger of the user touches the touch keycap 1 to trigger the capacitive sensing touch element 111 of the touch keycap, the touch keycap 1 is pressed down (for example, when the finger touches the wall of the touch side 121 of the keycap body 12, the keycap body 12 is pulled to a pressed state under the action of friction) to trigger the output of a key combination of "Alt+F4". In this way, with just one finger, the user achieves the triggering of the key combination that originally needs to be pressed with two fingers. Generally, for a key combination that originally needs to be pressed with n fingers simultaneously, the number of fingers needed can be reduced to n/2 (rounded up) by using the touch keycap 1, resulting in a doubling of interaction efficiency.

A 61-key 60% layout keyboard using the touch keycap 1 of the present disclosure can add 31 keys, increasing the number of keys by more than 50%, with the control experience significantly surpassing that of 65% and 80% layout keyboards without using the touch keycap 1 of the present disclosure. A 108-key 100% layout keyboard using the touch keycap 1 of the present disclosure can add 39 keys, increasing the number of keys by more than 36%. The improvement effect of the touch keycap of the present disclosure on 65% and 80% layout keyboards is between the improvement effect on the 60% layout keyboard and the improvement effect on the 100% layout keyboard. The added keys can be used to complete the key layout, and can also be customized to serve as shortcut start keys, configuration toggle keys, or shortcut trigger keys for commonly used key combinations in applications or scripts (macros), saving a lot of keyboard and mouse operations.

If the capacitive sensing touch element 111 is a touch slider, the touch slider can be triggered to achieve functions such as volume adjustment. When a user triggers the touch slider of the touch keycap 1, the user does not need to exit the posture of "typing with both hands". For example, the touch keycap 1 with the touch slider function is located at the position of the "Space" key. In this case, a slight movement of a thumb can trigger the touch slider. The coherence in posture can significantly improve interaction efficiency and help maintain the user's mental focus and coherent work thinking.

If the capacitive sensing touch element 111 is a touch pad, the touch pad can be triggered to achieve functions such as moving a mouse cursor.

Exemplarily, there are multiple touch keycaps 1. The capacitive sensing touch elements 111 of the multiple touch keycaps 1 are electrically connected to the same MCU 112 to form a touch key group, thereby reducing the number of MCUs 112, simplifying the circuit, and reducing costs. There are multiple touch key groups. Each of the touch key groups is provided with one MCU 112. Generally, 5 to 6 capacitive sensing touch elements 111 share one MCU 112, so multiple MCUs 112 are provided to meet the needs of more touch keycaps 1.

Generally, during keyboard production, the touch circuit of the touch keycap 1 is directly connected to the control circuit board 2 to achieve the connection and mounting of the touch keycap 1. For example, the keyboard further includes an adapter 21. The adapter 21 is provided with an input interface and an output interface. The control circuit board 2 is electrically connected to the input interface. The output interface is configured to achieve communication connection with the computer 3 (including wired communication connection and wireless communication connection). That is, the adapter 21 integrates a circuit of the control circuit board 2 with a circuit of the circuit board before it is connected to the computer 3, facilitating the replacement of the touch keycap 1. In addition, the setting of the adapter 21 makes it easy to change a traditional keyboard into a keyboard with the touch keycap 1 of the present disclosure.

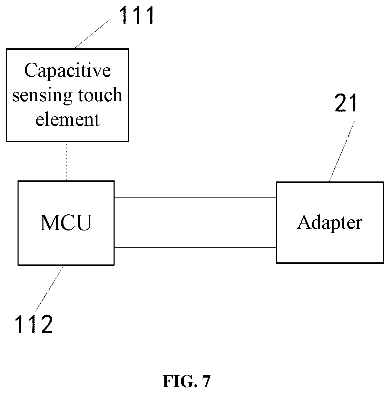

As shown in FIG. 7, the present disclosure further provides a keyboard touch input assembly, including a circuit board and an adapter 21 that is in communication connection with a control circuit board 2 of a keyboard and/or a computer 3. The communication connection includes wired communication connection and wireless communication connection. The wireless communication connection includes Bluetooth connection, wireless fidelity (WiFi) connection, etc. The keyboard touch input assembly can be powered by an independent battery or by a keyboard battery connected to the keyboard touch input assembly. The circuit board is provided with a touch circuit. The touch circuit is electrically connected to a capacitive sensing touch element 111. The circuit board is provided with the touch circuit. The capacitive sensing touch element 111 is one or more of a touch key, a touch slider, and a touch pad. The touch circuit is provided with a MCU 112. The MCU 112 is electrically connected to the capacitive sensing touch element 111 and the adapter 21 separately.

When the adapter 21 of the keyboard touch input assembly is in communication connection with the control circuit board 2 of a traditional keyboard, the keyboard touch input assembly is used in combination with the traditional keyboard, thereby modifying the traditional keyboard such that the keycap of the keyboard has an additional touch function. When the adapter 21 of the keyboard touch input assembly is in communication connection with the computer 3, the keyboard touch input assembly can be used independently, equivalent to an additional independent touch keyboard. In addition, the adapter 21 can be in communication connection with the control circuit board 2 of the keyboard and the computer 3 separately.

The above described are merely preferred implementations of the present disclosure. It should be noted that several improvements and replacements can be made by those of ordinary skill in the art without departing from the technical principle of the present disclosure, but such improvements and replacements should also be deemed as falling within the protection scope of the present disclosure.

## Claims

1. A touch keycap, comprising a circuit board and a keycap body, wherein the circuit board is located on the keycap body and/or a keyboard; the circuit board is provided with a touch circuit; the touch circuit is electrically connected to a capacitive sensing touch element; the capacitive sensing touch element is one or more of a touch key, a touch slider, and a touch pad; the touch circuit is provided with a microcontroller unit (MCU); the capacitive sensing touch element is electrically connected to the MCU; the capacitive sensing touch element is located at any position of an inner surface, an interior, and an outer surface of a top wall of the keycap body; alternatively, the capacitive sensing touch element is located at any position of an inner surface, an interior, and an outer surface of a side wall of the keycap body; and alternatively, the capacitive sensing touch element is located at an edge of the keycap body.

2. The touch keycap according to claim 1, wherein the circuit board comprises a touch region and an accommodation region; the capacitive sensing touch element is located in the touch region; the touch circuit is located in the accommodation region; and the accommodation region is located on the keycap body and/or the keyboard.

3. The touch keycap according to claim 2, wherein the circuit board is a flexible printed circuit board; the flexible printed circuit board is located on the keycap body; the touch region is fixed to the inner surface of the side wall of the keycap; and the accommodation region is located on an inner surface of a side wall of the keycap body adjacent to the touch region.

4. A keyboard, comprising a control circuit board and the touch keycap according to any one of claims 1 to 3, wherein the touch keycap is located at a key position of the keyboard; and the touch circuit is electrically connected to the control circuit board.

5. The keyboard according to claim 4, wherein the touch keycap is located at an edge key position of the keyboard; an outward side of the keycap body forms a touch side; and the capacitive sensing touch element is located at any position of an inner surface, an interior, and an outer surface of a wall of the touch side.

6. The keyboard according to claim 4, wherein there are multiple touch keycaps; the capacitive sensing touch elements of the multiple touch keycaps are electrically connected to the same MCU to form a touch key group.

7. The keyboard according to claim 6, wherein there are multiple touch key groups; and each of the touch key groups is provided with one MCU.

8. The keyboard according to claim 6, wherein the keyboard further comprises an adapter; the adapter is provided with an input interface and an output interface; the control circuit board is electrically connected to the input interface; and the output interface is configured to achieve communication connection with a computer.

9. A keyboard touch input assembly, comprising a circuit board and an adapter that is in communication connection with a control circuit board of a keyboard and/or a computer, wherein the circuit board is provided with a touch circuit; the touch circuit is electrically connected to a capacitive sensing touch element; the capacitive sensing touch element is one or more of a touch key, a touch slider, and a touch pad; the touch circuit is provided with a MCU; and the MCU is electrically connected to the capacitive sensing touch element and the adapter separately.
